# EUROPEAN PATENT APPLICATION

(11) **EP 4 746 596 A1**
(43) Date of publication of application: **20.05.2026**
(21) Application number: 24900250.2
(22) Date of filing: 13.09.2024
(51) Int. Cl.: H05K 3/46

(54) **MULTILAYER SUBSTRATE, METHOD FOR MANUFACTURING MULTILAYER SUBSTRATE, AND ELECTRONIC DEVICE**

(30) Priority: 08.12.2023 JP 2023207857
(71) Applicant: FICT LIMITED, Nagano-shi, Nagano 381-8501 (JP)
(72) Inventor: OZAKI, Norikazu, Nagano-shi, Nagano 381-8501 (JP); MIYAGAWA, Tetsuro, Nagano-shi, Nagano 381-8501 (JP); NAKAGAWA, Takashi, Nagano-shi, Nagano 381-8501 (JP); SAKAI, Naoki, Nagano-shi, Nagano 381-8501 (JP); TSUKADA, Hibiki, Nagano-shi, Nagano 381-8501 (JP)
(74) Representative: Hoffmann Eitle
(86) International application number: PCT/JP2024/032817
(87) International publication number: WO 2025/120953

(57) **Abstract**

Provided are a multilayer substrate that is capable of shortening a manufacturing process and decreasing a resistance value of a conductive paste, a method for manufacturing a multilayer substrate, and an electronic device. As the solution, a plurality of unit laminates (50) are laminated via an adhesive layer (38), each unit laminate (50) comprising: a first insulating layer (14); metal layers (20), (22) that are formed on both surfaces of the first insulating layer (14) and are interlayer-connected by a first via (18) containing a plating or a conductive paste; second insulating layers (24), (28) that are each laminated in a gap of the metal layers (20), (22), respectively; a third insulating layer (32) laminated on the second insulating layer (24) on the upper surface side; a second via (44) that is formed inside the third insulating layer (32), connects the metal layers (20) and other metal layers (22), and contains the conductive paste; and the adhesive layer (38), which is laminated on the third insulating layer (32). The solution also requires a condition, where the metal layers (20), (22) respectively have, in order from the upper surface of the first insulating layer (14): pattern-shaped portions (20c), (22c) formed in pattern shape and step portions (20b), (22b) that are formed at the same height as the pattern-shaped portions and are connected to the first via (18); and protruding portions (20a), (22a) that are formed on the surfaces of the step portions (20b), (22b) and are connected to the second via (44).

## Description

### Technical Field

The present invention relates to a multilayer substrate, a method for manufacturing a multilayer substrate, and an electronic device.

### Background Art

Conventionally, circuit boards such as printed wiring boards have been widely used to compactly incorporate electronic components into electronic devices. A printed wiring board is made by attaching copper foil to a laminate and etching it according to an electronic circuit pattern.

Meanwhile, with the demand for smaller sizes, higher performance, and lower prices for electronic devices, miniaturization and multilayering of electronic circuits on circuit boards and high-density mounting of electronic components have rapidly advanced, and studies on multilayer substrates have become active.

In this respect, PTL 1 (JP-A-2004-158671), for example, proposes, as a multilayer substrate, a build-up multilayer substrate formed by stacking insulating materials on which conductor patterns are formed in order on both sides of a base core member.

Also, PTL 2 (JP-A-2015-26689) proposes a multilayer substrate in which a plurality of insulating layers having conductive paste connected to metal layers are stacked with adhesive layers.

### Citation List

### Patent Literature

PTL 1: JP-A-2004-158671
PTL 2: JP-A-2015-26689

### Summary of Invention

### Technical Problem

Build-up type multilayer substrates such as those described in PTL 1 require significantly long time for a manufacturing process, and the yield per layer is reflected in the overall yield as a multiplier of the number of layers by a multilayering of layer, which results in the problem of high manufacturing costs.

Furthermore, the multilayer substrate disclosed in PTL 2 has the advantage of being able to shorten the manufacturing process compared to the build-up type multilayer substrate described above. However, because interlayer coupling is achieved using conductive paste, the resistance value of the conductive paste increases, resulting in the problem of a reduced allowable current value of the entire multilayer substrate.

### Solution to Problem

Thus, to solve the above problems, it is an object of the present invention to provide a multilayer substrate, a method for manufacturing a multilayer substrate, and an electronic device with which the manufacturing process is shortened, and the allowable current value is improved by reducing the resistance value of the conductive paste.

That is, a disclosed multilayer substrate requires that a plurality of unit laminated bodies each including a first insulating layer, metal layers formed on both sides of the first insulating layer with interlayer coupling therebetween provided by a first via including plating or conductive paste, a second insulating layer stacked in a gap in each of the metal layers, a third insulating layer stacked on the second insulating layer on one side, a second via that is formed inside the third insulating layer, connects the metal layer and another metal layer, and includes conductive paste, and an adhesive layer stacked on the third insulating layer, are stacked through the adhesive layer, and each of the metal layers formed on both sides of the first insulating layer includes, in order from a surface of the first insulating layer, a patterned portion formed in a pattern shape and a step portion formed at the same height as the patterned portion and connected to the first via, and then a protruding portion formed on a surface of the step portion and connected to the second via. This allows the manufacturing process to be shortened compared to a build-up type multilayer substrate. Also, by providing the metal layer with the protruding portion, the height of the conductive paste can be reduced, thereby reducing the resistance value of the conductive paste. That is, the allowable current value of the multilayer substrate can be improved.

Also, in the disclosed multilayer substrate, as for the surface roughness of the metal layer at the surface and the side surface of the patterned portion, the surface and the side surface of the step portion, and the side surface of the protruding portion, Rz is preferably about 2.0 µm or less, for example, in order to satisfy high-speed transmission characteristics. However, when Rz is reduced, it would be difficult to achieve close contact between the copper of the circuit and the insulating resin. As such, in the disclosed multilayer substrate, the metal layer preferably has adhesion-improving coating formed on the surface and the side surface of the patterned portion, the surface and the side surface of the step portion, and the side surface of the protruding portion.

Also, in the disclosed multilayer substrate, the protruding portion is preferably formed so as to have a diameter that decreases as the distance from the first insulating layer increases.

A disclosed method for manufacturing a multilayer substrate is required to include: a first step of manufacturing a unit laminated body including a first etching step of forming, on a first insulating layer with metal layers formed on both sides thereof, with interlayer coupling between the metal layers provided by a first via including plating or conductive paste, a protruding portion, and then a step portion connected to the protruding portion and a patterned portion having a same height as the step portion, by etching each of the metal layers from a surface side of the first insulating layer, in order then, a first stacking step of stacking a second insulating layer in a gap of each of the metal layers, then, a second stacking step of stacking a third insulating layer on the second insulating layer on one side, then, a third stacking step of stacking an adhesive layer on the third insulating layer, and then, a via forming step of forming a second via by forming a plurality of through-holes connected to the protruding portion in the adhesive layer and the third insulating layer and filling each of the through-holes with conductive paste; and then, a second step of stacking a plurality of the unit laminated bodies through the adhesive layer. This allows the manufacturing process to be shortened compared to a build-up type multilayer substrate. Furthermore, the height of the conductive paste can be reduced, thereby reducing the resistance value of the conductive paste. That is, the allowable current value of the multilayer substrate can be improved.

In the method for manufacturing a multilayer substrate, the first step preferably further includes a chemical adhesion step of forming adhesion-improving coating on the metal layer as a step subsequent to the first etching step, a first polishing step of polishing a surface of the second insulating layer and a surface of the protruding portion on a side where the third insulating layer is to be stacked to expose the surface of the protruding portion and remove the adhesion-improving coating on the surface of the protruding portion as a step subsequent to the first stacking step, and a second polishing step of polishing a surface of the second insulating layer and a surface of the protruding portion on a side where the third insulating layer is not to be stacked to expose the surface of the protruding portion and remove the adhesion-improving coating on the surface of the protruding portion as a step subsequent to the second stacking step.

Furthermore, in the disclosed method for manufacturing a multilayer substrate, in the first stacking step, the second insulating layer is preferably stacked so as to cover a surface of the metal layer, in the second stacking step, metal foil is preferably further stacked on a surface of the third insulating layer, and the first step preferably further includes a second etching step of removing the metal foil by etching as a step subsequent to the second stacking step.

A disclosed electronic device includes the above-described disclosed multilayer substrate and an electronic component.

### Advantageous Effects of Invention

According to the present invention, the manufacturing process can be shortened compared to a build-up type multilayer substrate. Furthermore, according to the present invention, since the metal layer has protruding portions, the height of the conductive paste can be reduced, thereby reducing the resistance value of the conductive paste. That is, the allowable current value of the multilayer substrate can be improved.

### Brief Description of Drawings

Fig. 1 is a schematic cross-sectional view showing an example of a method for manufacturing a multilayer substrate (part 1).
Fig. 2 is a schematic cross-sectional view showing an example of a method for manufacturing a multilayer substrate (part 2).
Fig. 3 is a schematic cross-sectional view showing an example of the method for manufacturing a multilayer substrate (part 3).
Fig. 4 is a schematic cross-sectional view showing an example of the method for manufacturing a multilayer substrate (part 4).
Fig. 5 is a schematic cross-sectional view showing an example of the method for manufacturing a multilayer substrate (part 5).
Fig. 6 is a schematic cross-sectional view showing an example of the method for manufacturing a multilayer substrate (part 6).
Fig. 7 is a schematic cross-sectional view showing an example of the method for manufacturing a multilayer substrate (part 7).
Fig. 8 is a schematic cross-sectional view showing an example of the method for manufacturing a multilayer substrate (part 8).
Fig. 9 is a schematic cross-sectional view showing an example of the method for manufacturing a multilayer substrate (part 9).
Fig. 10 is a schematic cross-sectional view showing an example of the method for manufacturing a multilayer substrate (part 10).
Fig. 11 is a schematic cross-sectional view showing an example of the method for manufacturing a multilayer substrate (part 11).
Fig. 12 is a schematic cross-sectional view showing an example of the method for manufacturing a multilayer substrate (part 12).
Fig. 13 is a schematic cross-sectional view showing an example of the method for manufacturing a multilayer substrate (part 13).
Fig. 14 is a schematic cross-sectional view showing an example of the method for manufacturing a multilayer substrate (part 14).
Fig. 15 is a schematic cross-sectional view showing an example of the method for manufacturing a multilayer substrate (part 15).
Fig. 16 is a schematic cross-sectional view showing an example of the method for manufacturing a multilayer substrate (part 16).
Fig. 17 is a schematic cross-sectional view showing an example of the method for manufacturing a multilayer substrate (part 17).
Fig. 18 is a schematic cross-sectional view showing an example of the method for manufacturing a multilayer substrate (part 18).
Fig. 19 is a schematic cross-sectional view showing an example of the method for manufacturing a multilayer substrate (part 19).
Fig. 20 is a schematic cross-sectional view showing an example of the method for manufacturing a multilayer substrate (part 20).
Fig. 21 is a schematic cross-sectional view showing an example of the method for manufacturing a multilayer substrate (part 21).
Fig. 22 is a schematic cross-sectional view showing an example of the method for manufacturing a multilayer substrate (part 22).
Fig. 23 is a schematic cross-sectional view showing an example of the method for manufacturing a multilayer substrate (part 23).
Fig. 24 is a schematic cross-sectional view showing an example of the method for manufacturing a multilayer substrate (part 24).
Fig. 25 is a schematic cross-sectional view showing an example of the method for manufacturing a multilayer substrate (part 25).
Fig. 26 is a schematic cross-sectional view showing an example of the method for manufacturing a multilayer substrate (part 26).
Fig. 27 is a schematic cross-sectional view showing an example of the method for manufacturing a multilayer substrate (part 27).
Fig. 28 is a schematic cross-sectional view showing an example of the method for manufacturing a multilayer substrate (part 28).
Fig. 29 is a schematic cross-sectional view of a semiconductor package.

### Description of Embodiments

Hereinafter, a multilayer substrate 100, a method for manufacturing a multilayer substrate, and an electronic device 200 in each embodiment will be described in detail with reference to the drawings. In all the drawings for illustrating the embodiments, the same reference numerals are used to designate components having the same functions, and repeated explanations thereof may be omitted.

Also, in the multilayer substrate 100, the method for manufacturing a multilayer substrate, and the electronic device 200, the terms "upper surface" and "lower surface" may be used, and these are expressed based on the up-down direction on the drawings, since the stacking direction of a unit laminated body 50 and a unit laminated body 52 described below is illustrated as the up-down direction in each drawing. That is, the upper surface and the lower surface of the multilayer substrate 100, the method for manufacturing a multilayer substrate, and the electronic device 200 may not agree with their actual up and down orientations.

Also, in the multilayer substrate 100, the method for manufacturing a multilayer substrate, and the electronic device 200, the term "surface" may be used, and "surface" means the "upper surface" or "lower surface" described above. Furthermore, in the multilayer substrate 100, the method for manufacturing a multilayer substrate, and the electronic device 200, the term "side surface" may be used, and "side surface" means the "side surface" with respect to the "upper surface" and "lower surface" described above.

### <Multilayer Substrate>

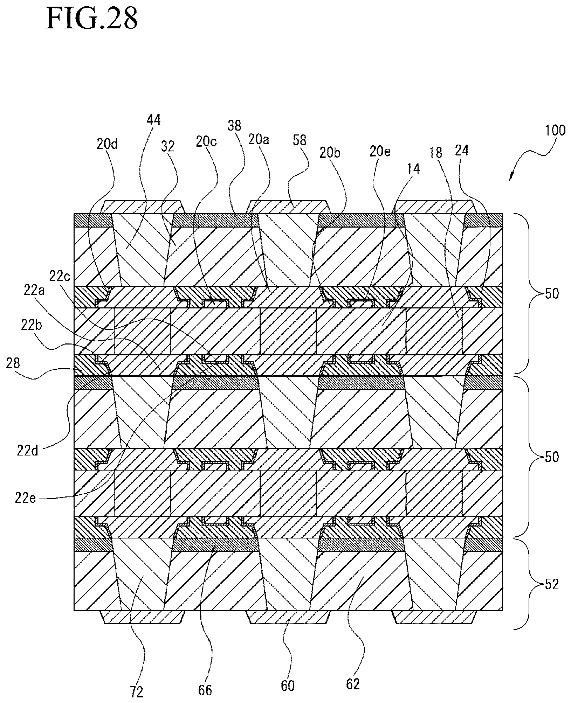

As shown in Fig. 28, the multilayer substrate 100 of the present embodiment has a configuration in which a plurality of unit laminated bodies 50 and the unit laminated body 52 are stacked.

Also, the unit laminated bodies 50 each include a first insulating layer 14, metal layers 20 and 22 formed on both sides of the first insulating layer 14 with interlayer coupling therebetween provided by first vias 18 including plating or conductive paste, second insulating layers 24 and 28 stacked in the gaps in the metal layers 20 and 22, a third insulating layer 32 stacked on one side (the upper surface side in this embodiment), second vias 44, which are formed inside the third insulating layer 32, connect the metal layer 20 to the metal layer 22 or the metal layer 58, and include conductive paste, and an adhesive layer 38 stacked on the third insulating layer 32. That is, the multilayer substrate 100 includes the first insulating layer 14, in which interlayer coupling between the metal layer 20 and the metal layer 22 is provided by the first vias 18 including plating or conductive paste, and the third insulating layer 32, in which interlayer coupling between the metal layer 20 and the metal layer 22 or the metal layer 58 is provided by the second vias 44. By stacking a plurality of such unit laminated bodies 50, the manufacturing process can be shortened compared to conventional build-up type multilayer substrates.

Also, the metal layer 20 on the upper surface side of the first insulating layer 14 includes, in order from the upper surface of the first insulating layer 14, a patterned portion 20c formed in a predetermined pattern and a step portion 20b formed at the same height as the patterned portion 20c and connected to the first via 18, and then a protruding portion 20a formed on the surface (upper surface) of the step portion 20b and connected to the second via 44. Also, the metal layer 22 on the lower surface side of the first insulating layer 14 includes a patterned portion 22c formed in a predetermined pattern and also includes, in order from the lower surface of the first insulating layer 14, a step portion 22b formed at the same height as the patterned portion 22c and connected to the first via 18, and a protruding portion 22a formed on the surface (lower surface) of the step portion 22b and connected to the second via 44.

The step portion 20b is formed in a flat plate shape (specifically a disk shape) with a thickness of about 18 to 35 µm, and the protruding portion 20a is formed in a truncated cone shape with a thickness of about 5 to 20 µm and a smaller diameter than the step portion 20b. Similarly, the step portion 22b is formed in a flat plate shape (specifically a disk shape) with a thickness of approximately 18 to 35 µm, and the protruding portion 22a is formed in a truncated cone shape with a thickness of about 5 to 20 µm and a smaller diameter than the step portion 22b. The protruding portion 20a and the step portion 20b are integrally formed, and the protruding portion 22a and the step portion 22b are integrally formed.

By configuring the metal layers 20 and 22 as described above, the height of the second via 44 can be lowered, thereby reducing the resistance value of the second via 44 including conductive paste, and improving the allowable current value of the entire multilayer substrate 100.

Furthermore, the metal layer 20 preferably includes adhesion-improving coating (inorganic or organic coating formed by a chemical adhesion step) 20d, 20e formed on the surface and the side surface of the patterned portion 20c, the surface and the side surface of the step portion 20b, and the side surface of the protruding portion 20a. Similarly, the metal layer 22 preferably includes adhesion-improving coating 22d, 22e formed on the surface and the side surface of the patterned portion 22c, the surface and the side surface of the step portion 22b, and the side surface of the protruding portion 22a. This ensures adhesion between the second vias 44 and the protruding portions 20a and 22a while protecting the high-speed signal lines of the metal layers 20 and 22, thereby improving the reliability of the entire multilayer substrate 100.

Furthermore, the protruding portions 20a and 22a are preferably formed so as to have a diameter that decreases as the distance from the first insulating layer 14 increases.

The multilayer substrate 100 also has a metal layer 58, which is located on the upper surface of the unit laminated body 50 of the uppermost layer, bonded by the adhesive layer 38, and connected to the second via 44. The metal layer 58 is formed in a pattern.

The unit laminated body 52 is the lowermost layer when stacked, and thus has a different configuration from the unit laminated body 50. That is, the unit laminated body 52 includes a metal layer 60, an insulating layer 62, conductive paste 72, and an adhesive layer 66, and has a configuration similar to the configuration of the upper side of the metal layer 20 of the unit laminated body 50. The metal layer 60 is formed in a pattern.

### <Method for Manufacturing Multilayer Substrate>

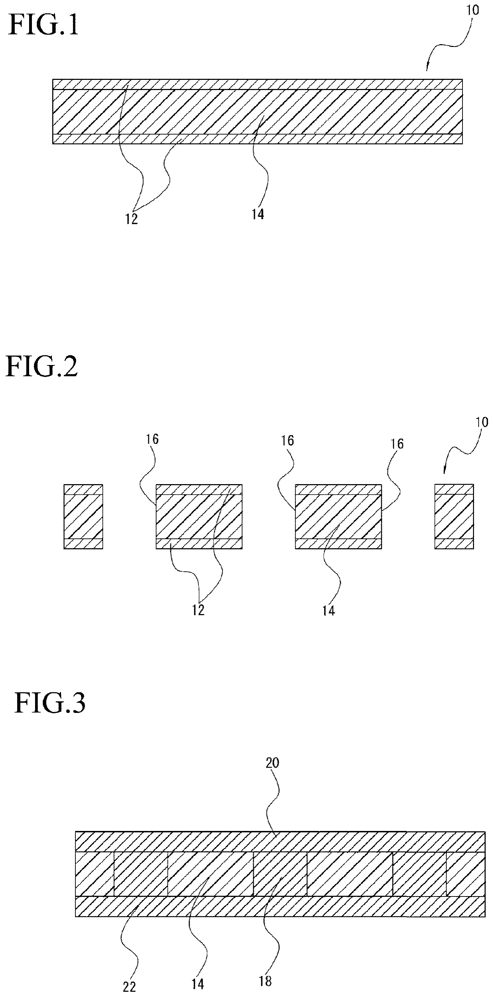

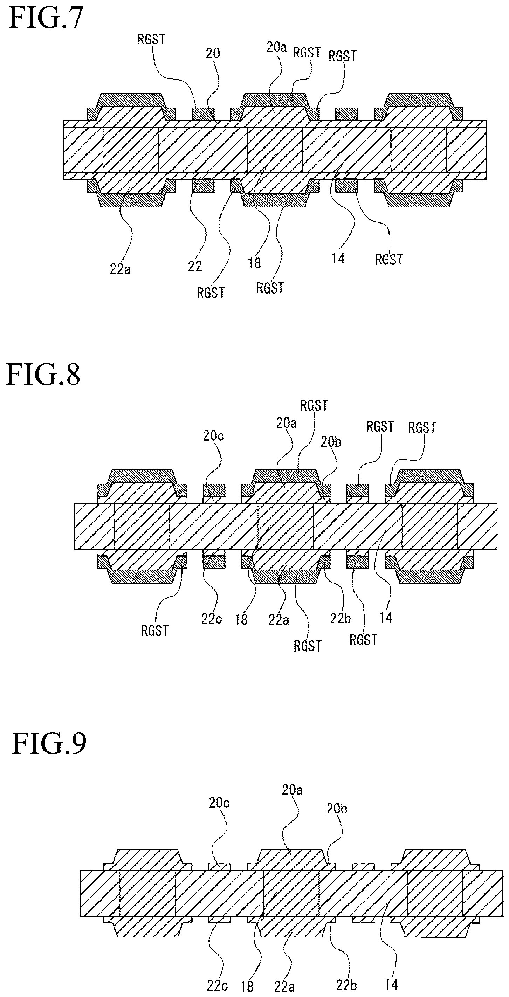

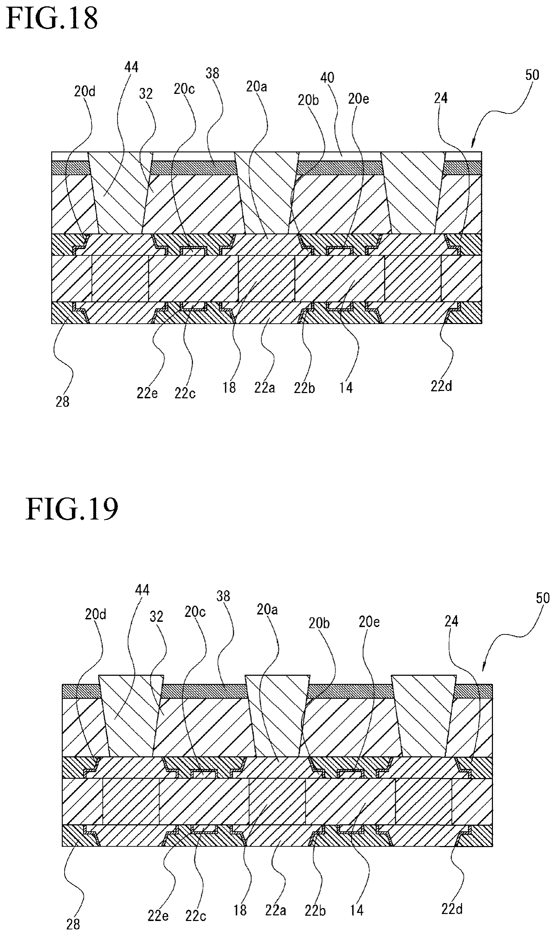

Referring to Figs. 1 to 28, a method for manufacturing a multilayer substrate according to the present embodiment is now described in detail.

The method for manufacturing a multilayer substrate includes a first step of manufacturing the unit laminated body 50 and a second step of stacking the plurality of unit laminated bodies 50.

First, as shown in Figs. 1 and 2, the method for manufacturing a multilayer substrate performs the step of preparing a support 10 and forming one or more through-holes 16 in the support 10.

In one example, the support 10 can be a copper-clad laminate (CCL) 10 in which copper foil 12 is affixed to the upper and lower surfaces of the first insulating layer 14, but it is not limited to this and can be selected appropriately depending on the purpose.

Also, the first insulating layer 14 is not particularly limited as long as it is an insulating layer used in a multilayer substrate, and can be selected appropriately depending on the purpose. The first insulating layer 14 may use, in one example, a base material whose hardness is reinforced by an inorganic base material such as an inorganic woven fabric or an inorganic nonwoven fabric using glass cloth or the like, or by an organic base material such as an organic woven fabric or an organic nonwoven fabric.

More specifically, the first insulating layer 14 may use, as one example, a glass epoxy base material (a glass woven-fabric base material impregnated with an epoxy resin, or a glass nonwoven-fabric base material impregnated with an epoxy resin), a glass woven-fabric base material impregnated with a bismaleimide triazine resin, an aramid nonwoven-fabric base material impregnated with an epoxy resin, or a glass woven-fabric base material impregnated with a modified polyphenylene ether resin. The glass epoxy base material is a base material obtained by impregnating glass fiber fabric (woven or nonwoven) with an epoxy resin.

Also, the insulating layer (first insulating layer) 14 is cured. The term "cured" refers to a state in which approximately 100% of the total heat generated during curing has been generated, and a state in which almost no heat generation can be observed when differential scanning calorimetry is performed, for example.

Also, the insulating layer (first insulating layer) 14 is generally flat-plate shaped. The average thickness of the insulating layer (first insulating layer) 14 may be, in one example, 10 µm or more and 200 µm or less, or 30 µm or more and 100 µm or less, but it is not particularly limited and can be selected appropriately depending on the purpose.

The through-holes 16 can be formed by laser processing, for example. The types of laser processing include CO₂ laser, YAG laser, and the like, but they are not limited to these and can be selected appropriately depending on the purpose.

Furthermore, the size (opening diameter) of the through-hole 16 may be 50 µm or more and 500 µm or less, or 100 µm or more and 300 µm or less, for example, but it is not limited to these and can be selected appropriately depending on the purpose.

The shape of the through-holes 16 in this embodiment is a through-hole drilled perpendicular to the first insulating layer 14, but it is not limited to this and can be selected appropriately depending on the purpose. Also, when the first via 18 is formed by filling with conductive paste as described below, the through-hole 16 may be formed in a shape in which its diameter gradually decreases from the side of the first insulating layer 14 where the conductive paste is filled (tapered shape).

As shown in Fig. 3, the method for manufacturing a multilayer substrate then performs the step of forming the first vias 18 including plating in the through-holes 16, and the step of forming the metal layers 20 and 22 connected to the first vias 18 by plating.

In one example, the plating may be performed by electrolytic copper plating or the like. In this case, the first vias 18 and the metal layers 20 and 22 are formed of copper.

Furthermore, the method for manufacturing a multilayer substrate may perform the step of forming the first vias 18 by filling the through-holes 16 with conductive paste, instead of the first vias 18 including plating. As the conductive paste, a paste containing a conductive filler and a binder resin may be used, but it is not limited to this and can be selected appropriately depending on the purpose. In one example, as the conductive filler, metal particles such as copper, gold, silver, palladium, nickel, tin, and bismuth may be used, and these metal particles may be used alone or in combination of two or more types. Furthermore, in one example, as the binder resin, an epoxy resin or a polyimide resin, which is a type of thermosetting resin, may be used, but it is not limited to these and can be selected appropriately depending on the purpose.

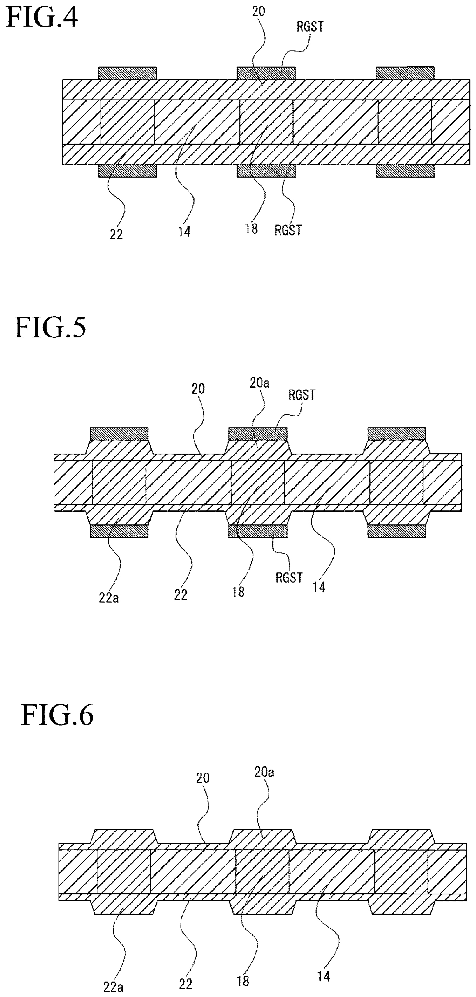

As shown in Figs. 4 to 9, the method for manufacturing a multilayer substrate then performs a first etching step of forming protruding portions 20a, step portions 20b, and patterned portions 20c in the metal layer 20 on the upper surface side, and forming protruding portions 22a, step portions 22b, and patterned portions 22c in the metal layer 22 on the lower surface side.

First, a film-shaped dry film resist is affixed to the surfaces of the metal layers 20 and 22. Then, unnecessary portions are removed through exposure to light using a predetermined pattern, so that a resist layer RGST is formed in the area where the protruding portions 20a are to be formed in the metal layer 20 and in the area where the protruding portions 22a are to be formed in the metal layer 22. Etching (half etching) is then performed to form the protruding portions 20a in the metal layer 20 and protruding portions 22a in the metal layer 22. In this etching (half etching), portions that become the step portions 20b and the patterned portions 20c remain in the metal layer 20, and portions that become the step portions 22b and the patterned portions 22c remain in the metal layer 22. The resist layer RGST is then removed.

Then, a film-shaped dry film resist is affixed to the surfaces of the protruding portions 20a and 22a and to the metal layers 20 and 22 remaining after etching (half etching). The unnecessary portions are then removed through exposure to light using a predetermined pattern, so that a resist layer RGST is formed in the areas where the protruding portions 20a and 22a, the step portions 20b and 22b, and the patterned portions 20c and 22c are to be formed. Etching is then performed, and then the resist layer RGST is removed. As a result, the step portions 20b and the patterned portions 20c can be formed in the metal layer 20, and the step portions 22b and the patterned portions 22c can be formed in the metal layer 22. It should be noted that the protruding portions 20a and 22a remain.

Forming the protruding portions 20a and 22a and step portions 20b and 22b in the metal layers 20 and 22 allows the height of the second vias 44 including conductive paste described below to be lowered, thereby reducing the resistance value of the second vias 44 and improving the allowable current value of the entire multilayer substrate 100.

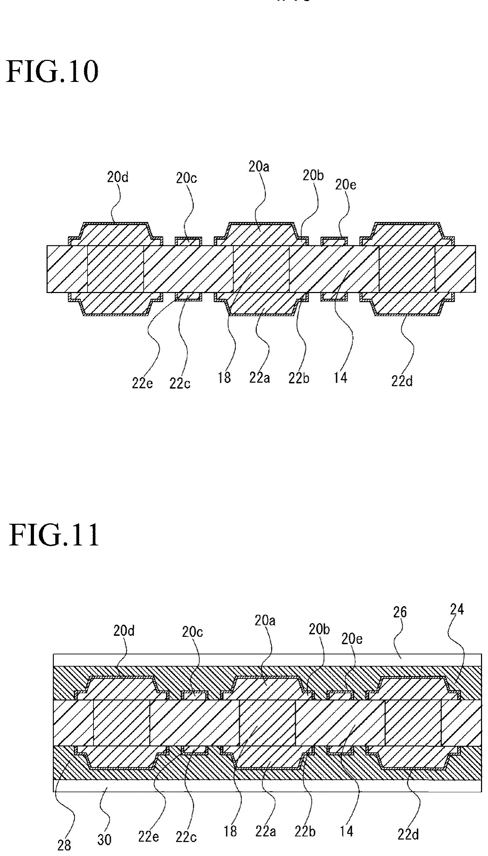

As shown in Fig. 10, the method for manufacturing a multilayer substrate then performs a chemical adhesion step of forming the adhesion-improving coating 20d and 20e on the metal layer 20 and forming the adhesion-improving coating 22d and 22e on the metal layer 22.

In the multilayer substrate 100, as for the surface roughness of the metal layers 20 and 22 at the surfaces and side surfaces of the patterned portions 20c and 22c, the surfaces and side surfaces of the step portions 20b and 22b, and the side surfaces of the protruding portions 20a and 22a, Rz is preferably about 2.0 µm or less, for example, in order to satisfy high-speed transmission characteristics. However, when Rz is reduced, it would be difficult to achieve close contact between the metal layers 20 and 22 and the insulating resin (second insulating layers 24 and 28). As such, in this embodiment, rather than modifying the surface roughness of the metal layers 20 and 22, it is preferable to apply inorganic or organic coating (adhesion-improving coating) to the surfaces and side surfaces of the metal layers 20 and 22 by a chemical adhesion step.

When the adhesion-improving coating 20d, 20e, 22d, 22e is inorganic coating, electroless plating can be used as the chemical adhesion step. More specifically, by electroless plating, for example, metals such as nickel, palladium, gold, and tin can be deposited on the surfaces of the metal layers 20 and 22 to form adhesion-improving coating (metal coating). In one example, the adhesion-improving coating (metal coating) 20d, 20e, 22d, 22e is formed to have a thickness of about 0.1 µm to 3 µm.

When the adhesion-improving coating 20d, 20e, 22d, 22e is organic coating, an organic solderability preservative (OSP) process or the like can be used as the chemical adhesion step. This allows the adhesion-improving coating (organic coating) 20d, 20e, 22d, 22e made of an azole compound or an imidazole compound, for example, to be formed on the surfaces of the metal layers 20 and 22. In one example, the adhesion-improving coating (organic coating) 20d, 20e, 22d, 22e is formed to have a thickness of about 0.1 µm to 3 µm.

By forming the adhesion-improving coating 20d, 20e, 22d, 22e on the metal layers 20 and 22, the high-speed signal lines of the metal layers 20 and 22 can be secured.

If high-speed transmission is required for the multilayer substrate 100 and the electronic device 200, it is preferable to use a chemical adhesion step, but if not, it is preferable to use a general roughening treatment (copper roughening treatment).

As shown in Fig. 11, the method for manufacturing a multilayer substrate then performs a first stacking step of stacking the second insulating layers 24 and 28 in the gaps in the metal layers 20 and 22.

The second insulating layers 24 and 28 are not particularly limited as long as they are insulating base materials used in a multilayer substrate, and can be selected appropriately depending on the purpose. More specifically, in one example, the second insulating layers 24 and 28 may use a thermosetting resin. As the thermosetting resin, fluororesin, polyphenylene ether resin (PPE/PPO resin), polyimide resin (PI resin), and bismaleimide triazine resin (BT resin) are preferred. These resins have a low dielectric constant and a low dielectric loss tangent. Thus, the use of these resins can reduce transmission loss of electrical signals.

The second insulating layers 24 and 28 may use a base material whose hardness is reinforced by an inorganic base material such as an inorganic woven fabric or an inorganic nonwoven fabric using glass cloth or the like, or by an organic base material such as an organic woven fabric or an organic nonwoven fabric. More specifically, the second insulating layers 24 and 28 may use a glass epoxy base material (a glass woven-fabric base material impregnated with an epoxy resin, or a glass nonwoven-fabric base material impregnated with an epoxy resin), a glass woven-fabric base material impregnated with a bismaleimide triazine resin, an aramid nonwoven-fabric base material impregnated with an epoxy resin, or a glass woven-fabric base material impregnated with a modified polyphenylene ether resin.

In the first stacking step, the above-mentioned uncured second insulating layer 24 and a resin film 26 are stacked in this order above the metal layer 20 on the upper surface side, the above-mentioned uncured second insulating layer 28 and a resin film 30 are stacked in this order below the metal layer 22 on the lower surface side, and thermocompression bonding is performed. After the thermocompression bonding, the resin films 26 and 30 are peeled off.

In one example, the thermocompression bonding can be performed at a temperature of 50°C or greater and 100°C or less, a pressure of 0.5 MPa or greater and 1.2 MPa or less, and a duration of 60 seconds or greater and 120 seconds or less, but it is not limited to these and can be selected appropriately depending on the purpose.

Furthermore, there are no particular limitations on the resin films 26 and 30 as long as they are resin films that do not melt during thermocompression bonding, and they can be selected appropriately depending on the purpose. As the examples, polyethylene terephthalate film, polyethylene naphthalate film, polyphenylene sulfite film, polyimide film, and the like may be used.

The thickness of the resin films 26 and 30 may be 10 µm or more and 150 µm or less, or 20 µm or more and 100 µm or less, but it is not limited to these and can be selected appropriately depending on the purpose.

Furthermore, the method for peeling off the resin films 26 and 30 is not particularly limited and can be selected appropriately depending on the purpose. In one example, a method can be used in which the ends of the resin films 26 and 30 are grasped with a jig and pulled away from the second insulating layers 24 and 28.

Alternatively, the first stacking step may use a method for stacking the second insulating layers 24 and 28 by screen printing.

In the first stacking step, the second insulating layers 24 and 28 are preferably stacked so as to cover the surfaces of the metal layers 20 and 22. That is, the second insulating layer 24 is preferably formed thicker than the metal layer 20, and the second insulating layer 28 is preferably formed thicker than the metal layer 22. In particular, in the first stacking step, the second insulating layer 28 is preferably stacked so as to cover the surface of the metal layer 22. This makes it possible to prevent the metal layer 22 on the lower surface side from being removed by etching when metal foil 34 described below is etched.

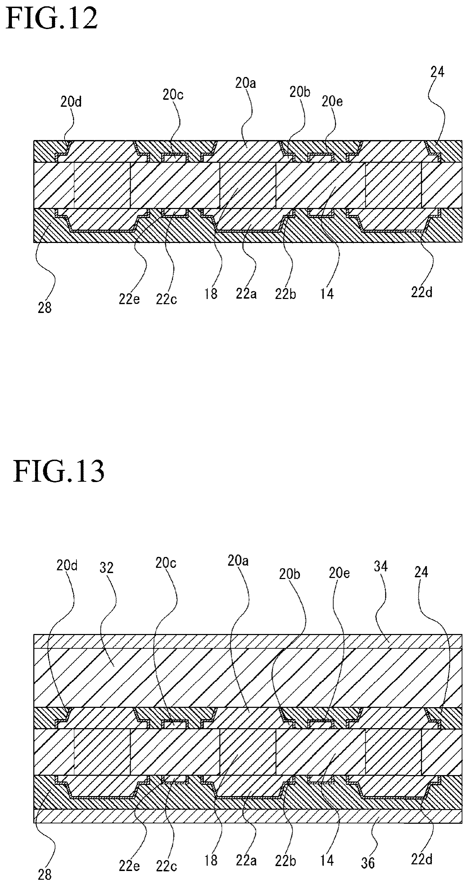

As shown in Fig. 12, the method for manufacturing a multilayer substrate then performs a first polishing step of polishing the surface (upper surface) of the second insulating layer 24 on the upper surface side and the surfaces (upper surfaces) of the protruding portions 20a of the metal layer 20 on the upper surface side to expose the surfaces of the protruding portions 20a and remove the adhesion-improving coating 20d on the surfaces of the protruding portions 20a. More specifically, polishing is performed using a polishing machine (not shown) such that the protruding portions 20a after removing the adhesion-improving coating 20d are flush with the second insulating layer 24. This increases the adhesion between the protruding portions 20a and second vias 44 described below, while protecting the high-speed lines of the metal layer 20.

When the resin films 26 and 30 are affixed to the second insulating layers 24 and 28, the resin films 26 and 30 are peeled off before polishing.

As shown in Fig. 13, the method for manufacturing a multilayer substrate then performs a second stacking step of stacking the third insulating layer 32 on the second insulating layer 24 on one side (upper surface side).

The third insulating layer 32 is not particularly limited as long as it is an insulating base material used in a multilayer substrate, and can be selected appropriately depending on the purpose. Also, the third insulating layer 32 is cured. The third insulating layer 32 may use, in one example, a base material whose hardness is reinforced by an inorganic base material such as an inorganic woven fabric or an inorganic nonwoven fabric using glass cloth or the like, or by an organic base material such as an organic woven fabric or an organic nonwoven fabric.

More specifically, the third insulating layer 32 may use, as one example, a glass epoxy base material (a glass woven-fabric base material impregnated with an epoxy resin, or a glass nonwoven-fabric base material impregnated with an epoxy resin), a glass woven-fabric base material impregnated with a bismaleimide triazine resin, an aramid nonwoven-fabric base material impregnated with an epoxy resin, or a glass woven-fabric base material impregnated with a modified polyphenylene ether resin.

The glass epoxy base material as the third insulating layer 32 and the glass epoxy base material as the first insulating layer 14 are preferably the same glass epoxy base material. This allows the characteristic values (volume contraction/expansion, mechanical rigidity, and the like) to be the same, thereby reducing the occurrence of warping of the multilayer substrate due to a difference in stress. This also eliminates effects on hardening, bonding state, and the like, which would otherwise be caused by migration of material components and moisture contained in the base material into the adjacent base material.

In the second stacking step, the metal foil (for example, copper foil) 34 may be affixed to the upper surface of the third insulating layer 32, and the third insulating layer 32 and the metal foil 34 may be stacked on the second insulating layer 24 and the protruding portions 20a by thermocompression bonding. Furthermore, in the second stacking step, metal foil (copper foil) 36 may also be affixed to the lower surface of the second insulating layer 28, and the above thermocompression bonding may be performed. This ensures the flatness of the unit laminated body 50 and improves the reliability of the multilayer substrate 100.

In one example, the thermocompression bonding can be performed at a temperature of 50°C or greater and 100°C or less, a pressure of 0.5 MPa or greater and 1.2 MPa or less, and a duration of 60 seconds or greater and 120 seconds or less, but it is not limited to these and can be selected appropriately depending on the purpose.

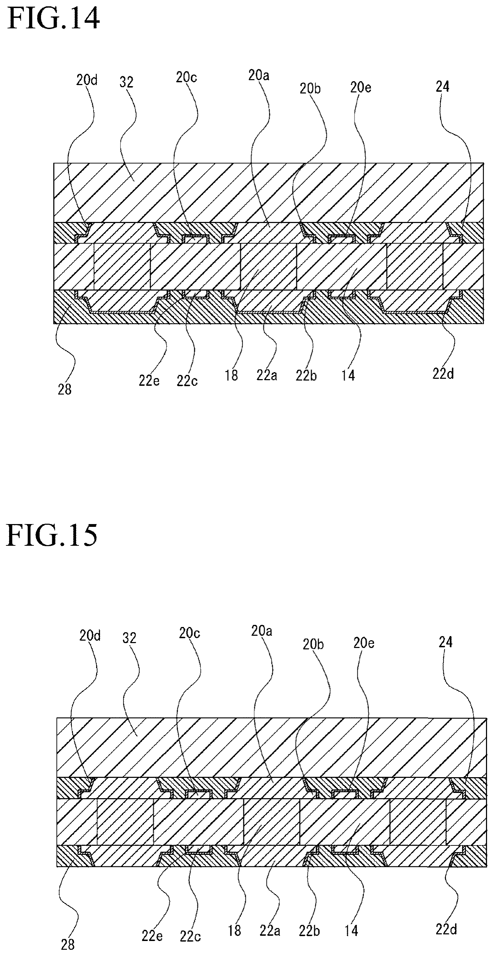

As shown in Fig. 14, the method for manufacturing a multilayer substrate then performs a second etching step of removing the metal foil 34, 36.

Even when the metal foil 36 is not affixed to the lower surface of the second insulating layer 28, the second insulating layer 28 covers the metal layer 22 on the lower surface side, so that the second insulating layer 28 serves as a barrier resin. This prevents the metal layer 22 from being etched.

As shown in Fig. 15, the method for manufacturing a multilayer substrate then performs a second polishing step of polishing the surface (lower surface) of the second insulating layer 28 on the lower surface side and the surfaces (lower surfaces) of the protruding portions 22a of the metal layer 22 on the lower surface side to expose the surfaces of the protruding portions 22a and remove the adhesion-improving coating 22d on the surfaces of the protruding portions 22a. More specifically, polishing is performed using a polishing machine (not shown) such that the protruding portions 22a after removing the adhesion-improving coating 22d are flush with the second insulating layer 28. This increases the adhesion between the protruding portions 22a and the second vias 44 in another unit laminated body, while protecting the high-speed lines of the metal layer 22.

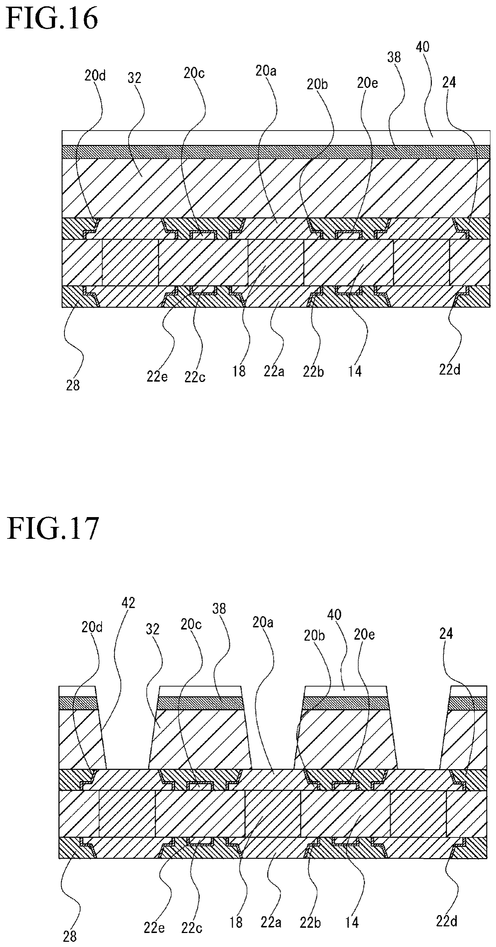

As shown in Fig. 16, the method for manufacturing a multilayer substrate then performs a third stacking step of stacking the adhesive layer (specifically, an insulating adhesive layer) 38 on the surface (upper surface) of the third insulating layer 32.

In one example, the adhesive layer 38 is an insulating adhesive 38, and a bonding sheet with a separator 40 stacked on top can be used.

As shown in Figs. 17 to 19, the method for manufacturing a multilayer substrate then performs a via forming step of forming second vias 44 by forming a plurality of through-holes 42 connected to the protruding portions 20a of the metal layer 20 on the upper surface side in the separator 40, the adhesive layer 38, and the third insulating layer 32, and filling the through-holes 42 with conductive paste 44. More specifically, the through-holes 42 are formed from the surface (upper surface) of the separator 40, the adhesive layer 38, and the third insulating layer 32 to the surfaces (upper surfaces) of the protruding portions 20a. Then, each through-hole 42 is filled with conductive paste (specifically, uncured conductive paste) 44, and the separator 40 is peeled off.

The through-holes 42 can be formed by laser processing. In one example, the types of laser include CO₂ laser, YAG laser, and the like, but they are not limited to these and can be selected appropriately depending on the purpose.

Furthermore, the size (opening diameter) of the through-hole 42 may be 50 µm or more and 500 µm or less, or 100 µm or more and 300 µm or less, for example, but it is not limited to these and can be selected appropriately depending on the purpose.

Also, the through-hole 42 in this embodiment is preferably formed in a shape in which the diameter gradually decreases from the surface (upper surface) side of the adhesive layer 38 toward the metal layer 20 (tapered shape).

As the conductive paste 44 with which the through-holes 42 are filled, a paste containing a conductive filler and a binder resin may be used, but it is not limited to this and can be selected appropriately depending on the purpose. In one example, as the conductive filler, metal particles such as copper, gold, silver, palladium, nickel, tin, and bismuth may be used, and these metal particles may be used alone or in combination of two or more types. Furthermore, in one example, as the binder resin, an epoxy resin or a polyimide resin, which is a type of thermosetting resin, may be used, but it is not limited to these and can be selected appropriately depending on the purpose.

By performing the above steps, the unit laminated body 50 can be manufactured.

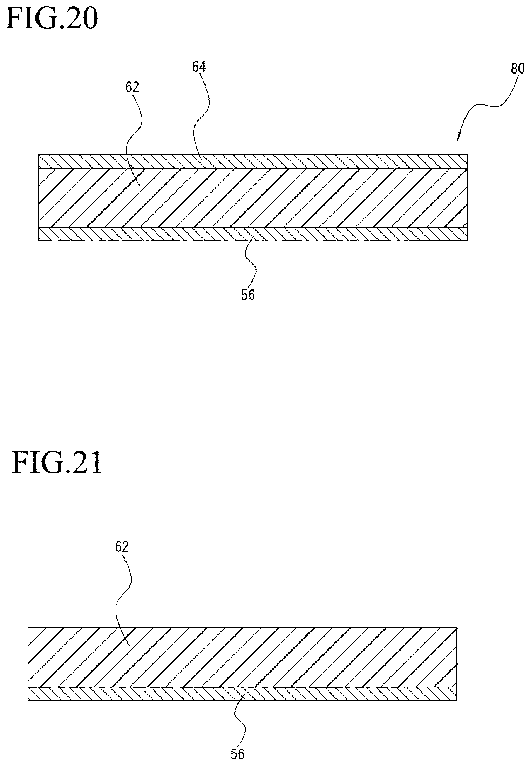

Referring to Figs. 20 to 25, a method for manufacturing the unit laminated body 52 located in the lowermost layer of the multilayer substrate 100 is now described in detail.

As shown in Figs. 20 and 21, the method for manufacturing the unit laminated body 52 first performs the step of preparing a support 80 and removing the metal foil 64 on the surface (upper surface) of the support 80 by etching.

In one example, the support 80 may use a copper-clad laminate (CCL) 80 in which metal foil (copper foil) 56, 64 is affixed to the upper and lower surfaces of the insulating layer 62, but it is not limited to this and can be selected appropriately depending on the purpose.

Also, the insulating layer 62 may use a base material similar to that of the first insulating layer 14. The glass epoxy base material as the insulating layer 62 and the glass epoxy base material as the first insulating layer 14 are preferably the same glass epoxy base material. This allows the characteristic values (volume contraction/expansion, mechanical rigidity, and the like) to be the same, thereby reducing the occurrence of warping of the multilayer substrate due to a difference in stress. This also eliminates effects on hardening, bonding state, and the like, which would otherwise be caused by migration of material components and moisture contained in the base material into the adjacent base material.

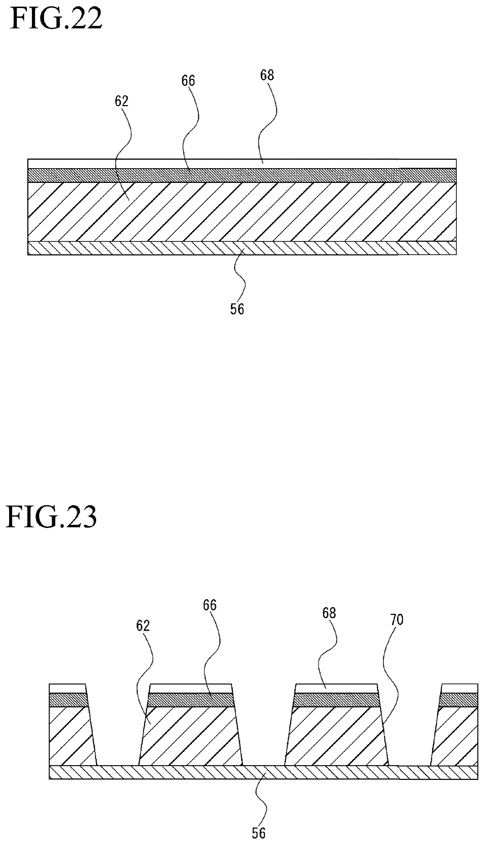

As shown in Fig. 22, the method for manufacturing the unit laminated body 52 then performs the step of stacking an adhesive layer (specifically, an insulating adhesive layer) 66 on the surface (upper surface) of the support 80 after etching.

In one example, the adhesive layer 66 is an insulating adhesive 66, and a bonding sheet with a separator 68 stacked on top can be used.

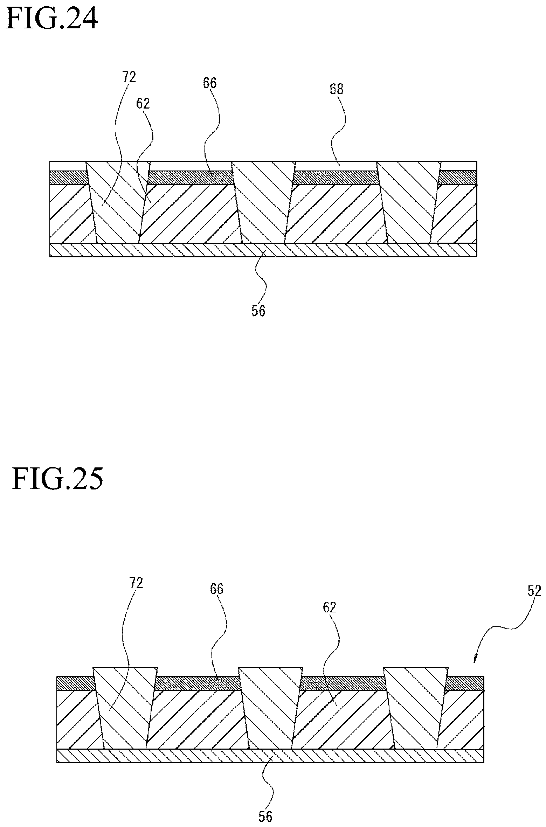

As shown in Figs. 23 and 24, the method for manufacturing the unit laminated body 52 then performs the step of forming third vias 72 by forming one or more through-holes 70 connected to the metal foil 56 in the separator 68, the adhesive layer 66, and the insulating layer 62, and filling the through-holes 70 with the conductive paste 72.

The through-holes 70 can be formed by laser processing. In one example, the types of laser include CO₂ laser, YAG laser, and the like, but they are not limited to these and can be selected appropriately depending on the purpose.

Furthermore, the size (opening diameter) of the through-hole 70 may be 50 µm or more and 500 µm or less, or 100 µm or more and 300 µm or less, for example, but it is not limited to these and can be selected appropriately depending on the purpose.

Also, the through-hole 70 in this embodiment is preferably formed in a shape in which the diameter gradually decreases from the surface (upper surface) side of the adhesive layer 38 toward the metal foil 56 (tapered shape).

The conductive paste 72 with which the through-holes 70 are filled may be similar to the conductive paste 44.

As shown in Fig. 25, the method for manufacturing the unit laminated body 52 then performs the step of peeling off the separator 68.

In this manner, the unit laminated body 52 located at the lowermost layer of the multilayer substrate 100 can be manufactured.

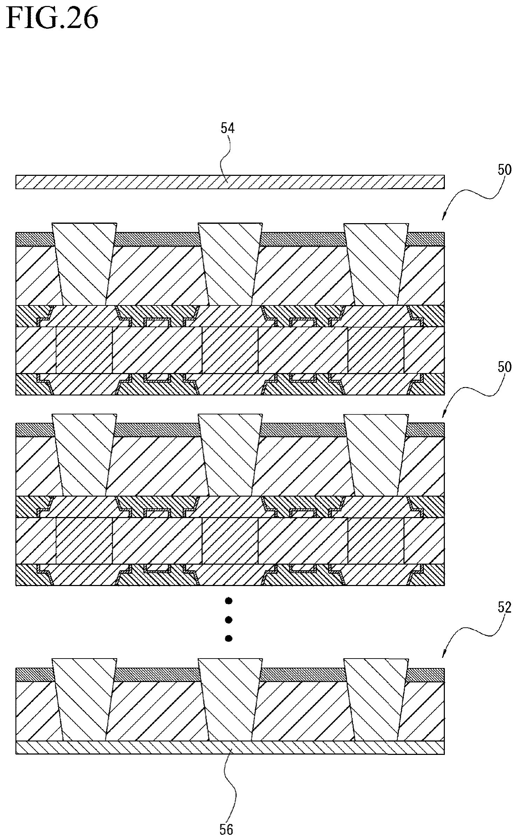

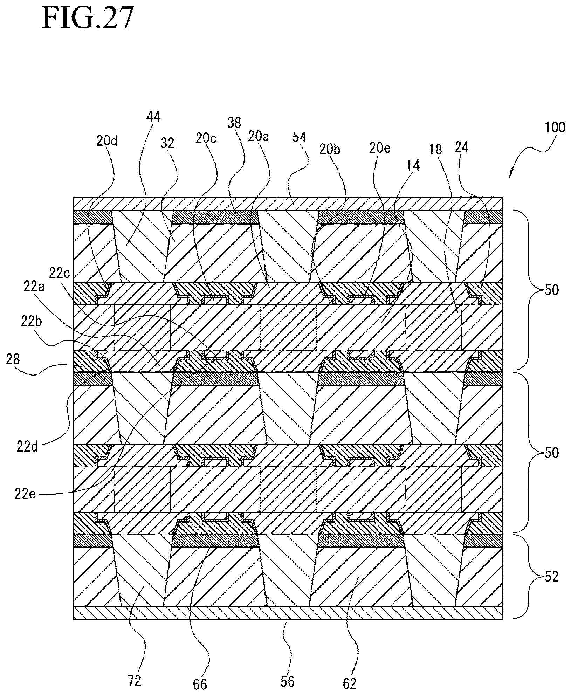

As shown in Figs. 26 and 27, the method for manufacturing a multilayer substrate then performs a second step of stacking the plurality of unit laminated bodies 50 and the unit laminated body 52. Additionally, metal foil 54 is stacked on the upper surface of the unit laminated body 50 of the uppermost layer. More specifically, to the protruding portions 22a of one unit laminated body 50, the second vias (uncured second vias) 44 of a different unit laminated body 50 on the lower side, or the third vias (uncured third vias) 72 of the unit laminated body 52 on the lower side are connected, the adhesive layer 38 of the different unit laminated body 50 on the lower side, or the adhesive layer 66 of the unit laminated body 52 on the lower side, is bonded to the second insulating layer 24 on the lower surface side of the one unit laminated body 50, and the entire multilayer substrate 100 is thermocompression bonded. As a result, the multilayer substrate 100, in which the metal foil 54 is stacked on the upper surface and the metal foil 56 is stacked on the lower surface as shown in Fig. 27, can be obtained.

Furthermore, as shown in Fig. 28, the method for manufacturing a multilayer substrate can obtain metal layers 58 and 60 having a pattern shape by performing predetermined etching on the metal foil 54 and the metal foil 56.

The multilayer substrate 100 can be obtained by the above-described method for manufacturing a multilayer substrate.

When the number of layers in the multilayer substrate 100 is an odd number, a metal layer, an insulating layer, and conductive paste may be further stacked on the unit laminated body 52 described above, and the stacked product may be stacked on the lowermost layer of the multilayer substrate 100.

### <Electronic Device>

The electronic device 200 according to the present invention is now described. The electronic device 200 includes at least the multilayer substrate 100 and an electronic component, and may further include other members as required.

The electronic device 200 is not particularly limited and can be selected appropriately depending on the purpose. Examples include personal computers (notebook computers, desktop computers), telephones, mobile phones, tablet-type mobile terminals, smartphones, copy machines, facsimiles, various printers, digital cameras, televisions, videos, CD devices, DVD devices, air conditioners, and remote control devices.

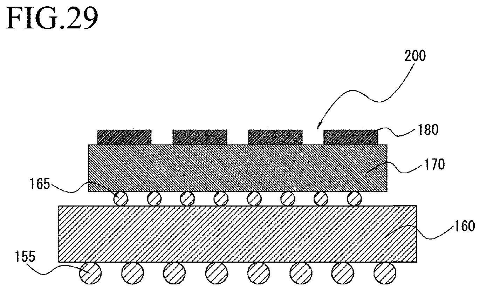

Fig. 29 shows a schematic cross-sectional view of a semiconductor package. The semiconductor package of Fig. 29 includes a motherboard 160 having solder balls 155, an interposer 170 connected to the motherboard 160 via bumps 165, and semiconductor devices 180 placed on the interposer 170. The semiconductor device 180 may be, for example, a field programmable gate array (FPGA) chip.

The multilayer substrate 100 can be used as the motherboard 160 in Fig. 29, as the interposer 170, and further as a multilayer substrate forming the semiconductor device 180.

## Claims

1. A multilayer substrate, wherein
a plurality of unit laminated bodies each including a first insulating layer, metal layers formed on both sides of the first insulating layer with interlayer coupling therebetween provided by a first via including plating or conductive paste, a second insulating layer stacked in a gap in each of the metal layers, a third insulating layer stacked on the second insulating layer on one side, a second via that is formed inside the third insulating layer, connects the metal layer and another metal layer, and includes conductive paste, and an adhesive layer stacked on the third insulating layer, are stacked through the adhesive layer, and
each of the metal layers formed on the first insulating layer includes, in order from a surface of the first insulating layer, a patterned portion formed in a pattern shape and a step portion formed at a same height as the patterned portion and connected to the first via, and then a protruding portion formed on a surface of the step portion and connected to the second via.

2. The multilayer substrate according to claim 1, wherein an adhesion-improving coating is formed on a surface and a side surface of the patterned portion, a surface and a side surface of the step portion, and a side surface of the protruding portion of the metal layer.

3. The multilayer substrate according to claim 2, wherein the protruding portion is formed so as to have a diameter that decreases as a distance from the first insulating layer increases.

4. A method for manufacturing a multilayer substrate, the method comprising:
a first step of manufacturing a unit laminated body including a first etching step of forming, on a first insulating layer with metal layers formed on both sides thereof, with interlayer coupling between the metal layers provided by a first via including plating or conductive paste, a protruding portion, and then a step portion connected to the protruding portion and a patterned portion having a same height as the step portion, by etching each of the metal layers from a surface side of the first insulating layer, in order,
then, a first stacking step of stacking a second insulating layer in a gap of each of the metal layers,
then, a second stacking step of stacking a third insulating layer on the second insulating layer on one side,
then, a third stacking step of stacking an adhesive layer on the third insulating layer, and
then, a via forming step of forming a second via by forming a plurality of through-holes connected to the protruding portion in the adhesive layer and the third insulating layer and filling each of the through-holes with conductive paste; and
then, a second step of stacking a plurality of the unit laminated bodies through the adhesive layer.

5. The method for manufacturing a multilayer substrate according to claim 4, wherein
the first step further includes a chemical adhesion step of forming adhesion-improving coating on the metal layer as a step subsequent to the first etching step, a first polishing step of polishing a surface of the second insulating layer and a surface of the protruding portion on a side where the third insulating layer is to be stacked to expose the surface of the protruding portion and remove the adhesion-improving coating on the surface of the protruding portion as a step subsequent to the first stacking step, and
a second polishing step of polishing a surface of the second insulating layer and a surface of the protruding portion on a side where the third insulating layer is not to be stacked to expose the surface of the protruding portion and remove the adhesion-improving coating on the surface of the protruding portion as a step subsequent to the second stacking step.

6. The method for manufacturing a multilayer substrate according to claim 5, wherein
in the first stacking step, the second insulating layer is stacked so as to cover a surface of the metal layer,
in the second stacking step, metal foil is further stacked on a surface of the third insulating layer, and
the first step further includes a second etching step of removing the metal foil by etching as a step subsequent to the second stacking step.

7. An electronic device in which an electronic component is mounted on the multilayer substrate according to any one of claims 1 to 3.
